# EUROPÄISCHE PATENTANMELDUNG

(11) **EP 1 376 870 A1**
(43) Veröffentlichungstag der Anmeldung: **02.01.2004**
(21) Anmeldenummer: 02360183.4
(22) Anmeldetag: 19.06.2002
(51) Int. Cl.: H03K 17/95

(54) **Näherungsschalter mit Anzeigemitteln und Anwendungsverfahren eines solchen Schalters**

(71) Anmelder: SENSTRONIC, S.A., F-67700 Saverne (FR)
(72) Erfinder: Kirchdoerffer, Rémy, 67110 Reichshoffen (FR); Schmidt, Ralf, 67251 Freinsheim (DE); Ebelt, Gerd, 67251 Freinsheim (DE)
(74) Vertreter: Nuss, Pierre

(57) **Zusammenfassung**

Die Erfindung betrifft einen Näherungsschalter, welcher nach einem induktiven oder kapazitiven Wirkprinzip arbeitet und einen LC-Schwingkreis und einen wirkverbundenden Verstärker beinhaltet, und bei welchem die Annäherung eines geeigneten becinflussenden Elements oder Gegenstandes wenigstens einen Schwingungsparameter verändert, wobei der Schaltzustand des Verstärkers verändert wird wenn der Gegenstand einen bestimmten Abstand zum Schwingkreis unterschreitet, wobei die Schwingung mit Erreichen des Schaltpunktes jedoch nicht abreisst.

Näherungsschalter (1), dadurch gekennzeichnet dass er ebenfalls Anzeigemittel (5) beinhaltet, welche in der Lage sind das Vorhandensein einer Beeinflussung des Schwingkreises (2) zu signalisieren, bevor der Schaltpunkt oder -wert des Verstärkes (3) erreicht wird.

## Beschreibung

Die vorliegende Erfindung bezieht sich auf das Gebiet der Abtastung und der Erfassung der Position und gegebenenfalls der Bewegung eines, zum Beispiel elektromagnetische Felder, beeinflussenden Gegenstandes, und betrifft einen kapazitiven oder induktiven Näherungsschalter oder -sensor, sowie ein Anwendungsverfahren eines solchen Schalters oder Sensors.

Sensoren die nach dem induktiven und kapazitiven Wirkprinzip arbeiten weisen gewöhnlich LC-Schwingkreise auf, wobei die Spule "L" der aktiven Fläche zugewendet ist und in ihren Eigenschaften von einem äusseren beeinflussenden, insbesondere bedämpfenden, zum Beispiel metallischen Element beeinflussbar ist.

Der LC-Schwingkreis bildet ein oszillierendes System, dass in einer bestimmten Frequenz selbsttätig schwingt. Durch die Beeinflussung der Spule sind die freien Schwingbedingungen nicht mehr gegeben, so dass die Schwingung abschwächt bzw. abreisst, bis das bedämpfende Element entfernt oder beseitigt ist und der Oszillator wieder weiter- oder anschwingen kann.

Sensoren dieser Art sind insbesondere aus den EP-Anmeldungen Nr. 01440262.2, Nr. 01440311.7 und Nr. 01440399.2 bekannt.

Jedoch können sich die Einstellungen solcher Sensoren, je nach den spezifischen Gegebenheiten der verschiedenen möglichen Applikationen, als sehr zeitaufwendig und delikat erweisen.

Insbesondere hat der Installateur keine Angabe darüber wie empfindlich der montierte Sensor ist, d. h. wie nahe er vom Schaltpunkt entfernt ist in Abwesenheit jeglicher Beeinflussung.

Weiterhin kann auch einer Änderung des potentiell beeinflussenden Umfelds nicht Rechnung getragen werden.

Zu diesem Punkt muß bemerkt werden, dass auf jeden Fall schon eine Beeinflussung des Sensors vorhanden ist (durch das Umfeld), ohne dass das zu detektierende Element vorhanden ist oder sich in einem nicht zu detektierenden Abstand befindet.

Der springende Punkt ist dabei, dass die Intensität dieser "Vorbeeinflussung" je nach Applikation sehr unterschiedlich ist, dass sich somit der Sensor in einige Fällen in einem Zustand nahe dem Schaltpunkt befinden kann.

Im Stand der Technik wird dieser Lage nicht in angemeßener Weise Rechnung getragen.

Der vorliegenden Erfindung liegt die Aufgabe zugrunde einen Näherungsschalter oder -sensor zu beschaffen, welcher in der Lage ist mindestens einige der hiervor angegebenen Mängel zu beheben.

Die Erfindung sollte unter anderem ermöglichen die Signalisierung (als Anzeige oder Schaltausgang) eines Bereichs bereitzustellen, der vor dem Erreichen des Schaltpunktes zeigt, dass bereits eine Beeinflussung vorhanden ist, und gegebenenfalls kurz nach dem Schaltpunkt mitteilt, dass dieser nur knapp erreicht wurde.

Hierzu betrifft die Erfindung einen Näherungsschalter oder -sensor, welcher nach einem induktiven oder kapazitiven Wirkprinzip arbeitet und einen LC-Schwingkreis und einen wirkverbundenden Verstärker beinhaltet, und bei welchem die Annäherung eines geeigneten beeinflussenden Elements oder Gegenstandes wenigstens einen Schwingungsparameter verändert, wobei der Schaltzustand des Verstärkers verändert wird wenn der Gegenstand einen bestimmten Abstand zum Schwingkreis unterschreitet, wobei frei oder, z.B. die durch Impuls fremderregte Schwingung mit Erreichen des Schaltpunktes jedoch nicht, oder zumindest nicht sofort, abreisst, dadurch gekennzeichnet dass er ebenfalls Anzeigemittel beinhaltet, welche in der Lage sind das Vorhandensein einer Beeinflussung des Schwingkreises zu signalisieren, bevor der Schaltpunkt oder -wert des Verstärkes erreicht wird.

Somit wird die Signalisierung über "n" Ereignisse, mit n ≥ 1, ermittelt und kann somit schon einmalige bis hin zu stark gefilterten Ereignissen, melden.

Zudem kann die Signalisierung in verschiedenen Formen Ausdruck finden, wie zum Beispiel Tonsignal, Lichtsignal, Angabe einer Nachricht, Schaltsignal, usw.

Gemäss eines vorteilhaften Merkmals der Erfindung sind die Anzeigemittel auch dann noch aktiv, d. h. das Vorhandensein einer Beeinflussung des Schwingkreises signalisieren, wenn der Schaltpunkt erreicht und überschritten ist.

Einer ersten Ausbildung der Erfindung folgend, können die Anzeigemittel so eingestellt sein, dass sie aktiv sind wenn die Intensität der Beeinflussung des Schwingkreises innerhalb wenigstens eines Fühlungsbereichs liegt, welcher den Intensitätwert der dem Schaltpunkt entspricht umgibt und beinhaltet.

Einer weiteren alternativen Ausbildung der Erfindung folgend, können die Anzeigemittel aktiv sein solange sich die Intensität der Beeinflussung des Schwingkreises überhalb eines ersten niedrigeren unteren Schwellenwertes und unterhalb eines zweiten höheren oberen Schwellenwertes befindet, wobei diese Schwellenwerte den Intensitätswert der dem Schaltpunkt entspricht beidseitig umgeben.

Vorteilhafterweise liegen der untere bzw. obere Schwellenwert ungefähr 5 % bis 20 %, vorzugsweise ungefähr 10%, unter bzw. über dem Intensitätswert der dem Schaltpunkt entspricht.

Der Sensor oder das Bestätigungselement wird vorzugsweise so einjustiert, dass über dem Toleranzbereich (wie z.b. Temperaturfunktionsbereich) des Sensors, ein sicherer Betrieb des letzteren garantiert wird.

Gemäss der Normen bzg. der Schaltbereiche der induktiven Sensoren werden folgende Schaltabstandabweichungen toleriert (Sₙ = nominaler Schaltabstand):
- Toleranz durch Streuung: +/- 10 %,
- Einwirkung der Temperatur : +/- 10 %.

Somit sollte die erfindungsgemäße Signalisierung über den Bereich: 0,81 Sₙ bis 1,21 Sₙ erfolgen.

Um die Lage des Beeinflussungspegels gegenüber dem Schaltwert einfach ausfindig machen zu können, können die Anzeigemittel, wenn sie aktiv sind, verschiedene Signale abgeben (z. B. zwei unterschiedliche Signale), je nachdem ob die Intensität der Beeinflussung des Schwingkreises den Intensitätswert, der dem Schaltpunkt entspricht, überschritten hat oder nicht.

Zur Bewertung der Beeinflussung des Schwingkreises herangezogene Parameter können aus der Gruppe ausgewählt werden, welche die Amplitude, die Phase und die Frequenz beinhaltet.

Gemäß einer praktischen erfindungsgemässen Lösung ist das von den Anzeigemitteln abgegebene Signal, ein Signal beliebiger Form ist, wie z.B. ein Rechtecksignal, welches den Zustand oder die Lage der momentanen Intensität der Beeinflussung des Schwingkreises gegenüber dem Fühlungsbereicht und/oder den Schwellenwerten statisch, dynamisch, zeitlich verzögert oder mittels Einwirkung einer anderen Funktion angibt.

Damit sich die Anzeigemittel verschiedenen elektromagnetischen Umfeldern anpassan können und auch ein auf einfache Weise verwertbares Signal abgeben, ist (sind) der Fühlungsbereich, der einem aktiven Zustand der Anzeigemittel entspricht, oder die Schwellenwerte einstellbar, wobei die Anzeigemittel einen Schaltverstärker beinhalten oder diesen Anzeigemitteln ein Schaltverstärker wirkverbunden nachgeschaltet ist.

Die Erfindung hat ebenfalls zum Gegenstand ein Anwendungsverfahren eines Näherungsschalters oder -sensors wie er hiervor beschrieben ist.

Dieses Verfahren weist hauptsächlich folgende Schritte auf:
- Montage des den Schalter oder Sensor beinhaltenden Gehäuses am Verwendungsort;
- Durchführung eines Kalibrierungs- bzw. Einstellungsvorganges des Schalters oder Sensors, nämlich des Schwingkreises und der Anzeigemittel, und der gegebenenfalls jeweils wirkverbundenen elektronisch (z.B. Verstärker), in Anwesenheit der anwendungsüblichen Arbeits-umgebung jedoch in Abwesenheit des im Arbeitsgang zu erfassenden, beeinflussenden Elements oder Gegenstandes, mindestens durch Entfernung aus dem Erfassungsbereich des Schalters oder Sensors;
- Verwendung des eingestellten Schalters oder Sensors als Näherungsschalter oder Anwesenheitsschalter, nach Beendigung des vorher gebenden Schritten.

Einer bevorzugten Weiterbildung der Erfindung folgend kann vorgesehen werden, dass der Kalibrierungs- bzw. Einstellungsvorgang wiederholt wird, zum Beispiel nach jeder Änderung der Arbeitsumgebung des Schalters oder Sensors, während das beeinflussende Element weit ausserhalb des Erfassungsbereichs liegt.

In der folgenden Beschreibung wird nun die Erfindung an Hand von Ausführungsbeispielen näher erläutert, dies im Zusammenhang mit den anliegenden schematischen Figuren.

Es zeigen:

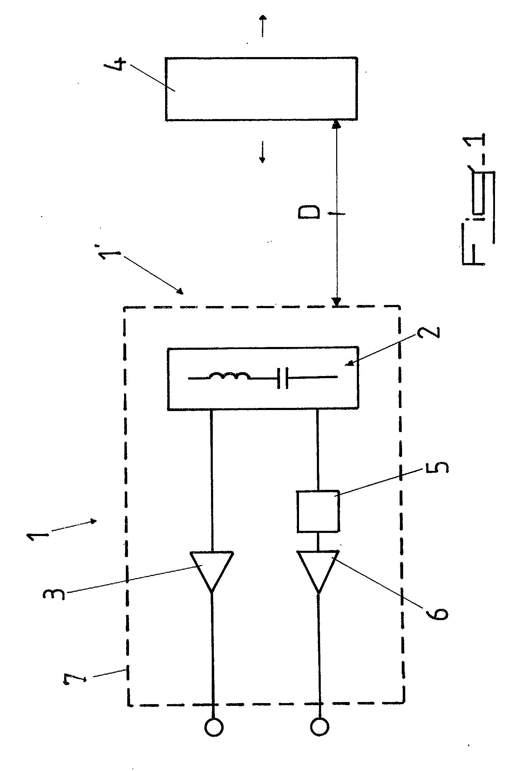

Figur 1: eine schematische Blockdarstellung eines Näherungsschalters gemäss der Erfindung;

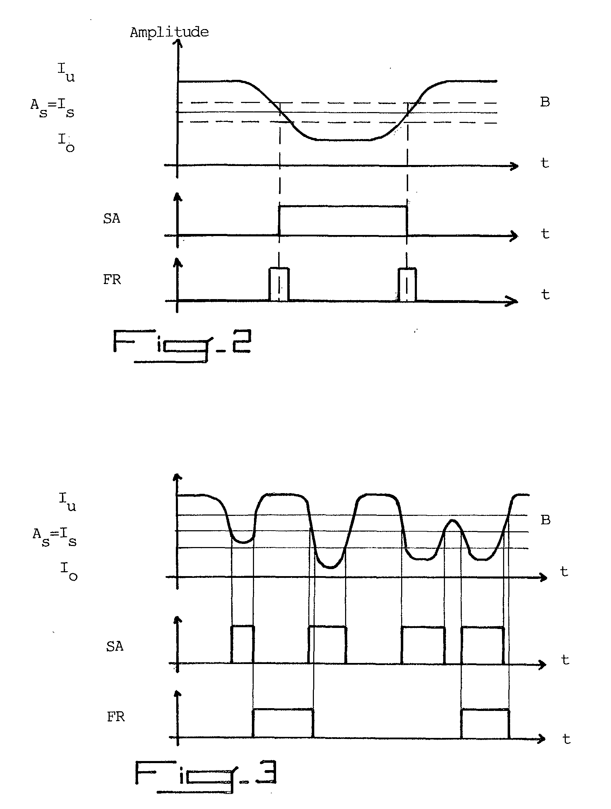

Figur 2: synchrone Zeitdiagramme welche die Entwicklungen der Amplitude, des Ausgangssignals SA des Sensors (Schaltverstärker) und das Ausgangssignals SR der Anzeigemittel (Schaltverstärker) illustrieren, im Falle einer starken elektromagnetischen Beeinflussung durch ein geeignetes Element, gemäss einer statischen Auswertung der Beeinflussung durch die Anzeigemittel;

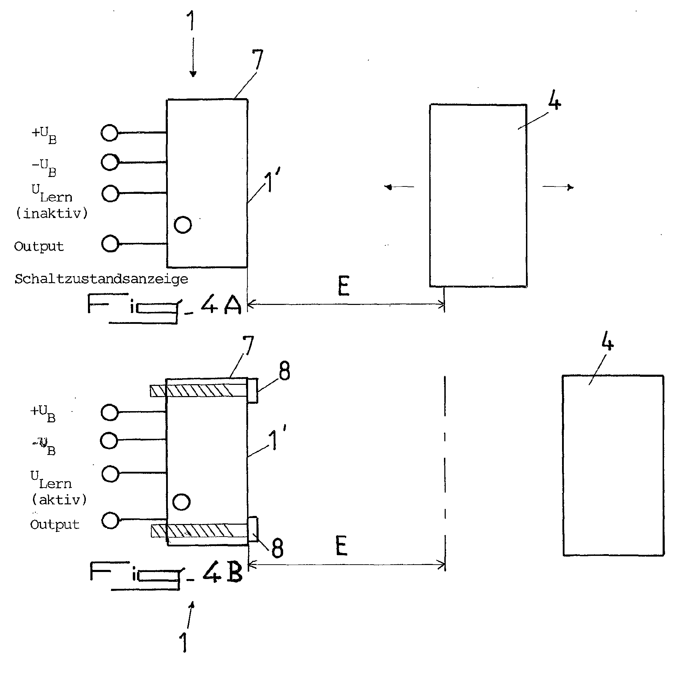

Figur 3: synchrone Zeitdiagramme welche die Entwicklungen der Amplitude, des Ausgangssignals SA des Sensors und des Ausgangssignals SR der Anzeigemittel illustrieren, im Falle wiederholter starker elektromagnetischer Beeinflussungen des Schwingkreises durch ein geeignetes Element, gemäss einer dynamischen Auswertung der Beeinflussung durch die Anzeigemittel;
Figur 4A und 4B: schematische Darstellungen des Näherungsschalters oder -sensors und des entsprechenden beeinflussenden Elements, welche ihre bezügliche Lage während des normalen Arbeitsbetrieb und während des Einstellungsvorgangs veranschaulicht.

Wie dies aus den Figuren 1, 4A und 4B hervorgeht, handelt es sich um einen Näherungsschalter oder -sensor 1 der nach einem induktiven oder kapazitiven Wirkprinzip funktioniert und einen abgestimmten LC-Schwingkreis 2 beinhaltet.

Durch Annäherung, vor der Seite der aktiven Fläche 1' her, eines elektromagnetische Felder beeinflussenden Materials wird, wenn der Gegenstand 4 aus diesen Materialen oder dieses Material tragend einen vorgegebenen Abstand D unterschreitet, der Schaltzustand des dem Schwingkreis 2 wirkverbundenen Schaltverstärkers 3 verändert.

Der Schwingkreis 2 ist so ausgelegt und erregt, dass die entsprechende Oszillatorschwingung mit Erreichen des Schaltpunktes nicht abreisst.

Wie vorher schon angegeben, sind zusätzliche Anzeigemittel 5 vorhanden, die in der Lage sind zu signalisieren, dass bereits vor Erreichen des Schaltpunktes eine Beeinflussung durch die Anwesenheit oder die Annäherung eines Materials, das das elektromagnetische Feld beeinflusst, vorhanden ist, wobei diese Signalisierung erst erlischt oder inaktiv wird wenn der nachgeschaltete Schaltverstärker 3 sicher seinen Schaltzustand geändert hat.

Es wird somit ein Sicherheitsbereich B definiert, der voreingestellt oder einstellbar ist und zum Beispiel so ausgelegt ist, dass 10% vor dem Schaltpunkt die Anzeige kommt und 10% nach dem Schaltpunkt die Anzeige erlischt.

Auf den Figuren 2 und 3 sind diese Schwellenwerte mit Iu und Io angegeben und grenzen einen Fühlungsbereich B ab (Sicherheitsbereich).

Die so bestimmte Funktionsreserve-Anzeige kann statisch, dynamisch oder zeitlich verzögert funktionieren oder sonstigen Zeitfunktionen unterliegen sein.

Zudem können diese Anzeigemittel 5 mit einem nachgeschalteten Schaltverstärker 6 versehen sein, um mit oder ohne Anzeige Veränderungen im Sensorumfeld frühzeitig zu erfassen, wie zum Beispiel Schweissspritzer auf der Sensorfläche 1'.

Ferner kann die Empfindlichkeit des Spulensystems des Schwingkreises auf äussere Einflüsse wie auch immer vom Anwender einstellbar sein ("Poti Teach In" oder ähnliches) und gegebenenfalls der Sensor 1 seine Empfindlichkeitseinstellung selbst durch geeignete Algorithmen verändern und den vorhandenen Bedürfnissen anpassen.

Die hiervor erläuterte Signalisierung kann verschiedenen Zwecken dienen:
a) die mechanische Einstellung oder Justage in der Applikation wird sicherer, weil kritische Bereiche um den Schaltpunkt herum gemieden werden, wenn zum Beispiel ein BE (beeinflussendes Element) erkannt werden soll, wobei ohne BE der Hintergrund schon zu einer Beeinflussung führt, dabei kann sowohl die Schaltschwelle als auch die Verstärkung auf die Applikation optimiert werden,
b) Einflüsse durch das Umfeld, die die Funktion des Sensors beeinträchtigen, und drohen zu Fehlsignalen zu führen, werden rechtzeitig erkannt, in einer Phase, wo der Sensor noch seine volle Funktion hat,
c) die Empfindlichkeit kann in gewissen Grenzen permanent nachgeführt werden (selbstlernend), zum Beispiel bei Verschmutzung durch Schweissspritzer.

Solch eine Signalisierung kann insbesondere dazu dienen die Empfindlichkeit eines induktiven oder kapazitiven Sensors durch Einlernen auf die Umgebung zu verbessern.

In der Tat, für einen induktiven Sensor 1 mit einer besonders grossen Reichweite (Erfassungsbereich E), d. h. mit hoher Empfindlichkeit, kann sich dessen Verhalten in einer veränderten Umgebung ungünstig verändern.

Befinden sich zum Beispiel Metallteile in der Nähe oder wird der Sensor 1 (durch sein Gehäuse 7) mit Metallschrauben 8 montiert, so könnte er unter Umständen auf Grund dieser geänderten Umgebung bereits ein Ausgangssignal liefern, welches einem erkannten Objekt entspräche. Der Sensor 1 würde dann folglich eine Fehlfunktion zeigen.

Entsprechend schwierig wird es somit, einen derart hochempfindlichen Sensor 1 für eine beliebige Applikation, also für verschiedene Kunden, gleichermassen zu optimieren. Hieraus folgt, im Einklang mit der Erfindung, die Überlegung, dass dieser Sensor 1 sich auf eine Einsatzumgebung einlernen muss, mittels eines Einstellungsprozesses.

Das Einlernen der Umgebung erfolgt wahlweise entweder automatisch nach dem Einschalten als sogenannte "Power-up-Funktion" oder man definiert eine Steuerleitung, um mit einem Steuersignal U_{Lern} den Einlernvorgang zu einem beliebigen Zeitpunkt auslösen zu können. Während dieser Phase muss der Anwender sicherstellen, dass sich das zu erfassende Objekt (Gegenstand 4) weit ausserhalb des Schaltbereiches E (Erfassungsbereich) des Sensors 1 befindet. Alle anderen Metallteile in der Nähe des Sensors 1 werden nun als dessen "natürliche Umgebung" erkannt und eingelernt.

Im Sensor 1 erfolgt während des "Einlernbetriebs" intern ein Anpassen der Schaltschwelle (As = Is) (bzw. des Schaltpunktes), dies entsprechend der umgebungsbedingten Veränderung des vom Sensor 1 erzeugten Magnetfeldes. Diese Schwelle wird am Ende des Einlernvorgangs im Sensor 1 gespeichert. Sie dient dann später, während des "Arbeitsbetriebs" als Vergleichsschwelle (As = Is).

Ist die detektierte Signaländerung während des Arbeitsbetriebs kleiner als die zuvor durch die Umgebung verursachte Signaländerung (diese entspricht dem gespeicherten Schwellenwert), so wird "kein Objekt erkannt". Im anderen Fall, bei einer grösseren Signaländerung, wird "das Objekt erkannt". Der Sensor 1 wechselt den Schaltzustand beim Überschreiten dieser Schwelle.

Es sollte zusätzlich noch bemerkt werden, dass obwohl die Erfindung im Zusammenhang mit einem Sensor 1 beschrieben wurde, sie auch ohne weiteres in sogenannten Abfragesets verwendet werden.

Selbstverständlich ist die Erfindung nicht auf die beschriebenen und dargestellten Ausführungsformen begrenzt. Änderungen, z. B. in den Ausführungformen der verschiedenen Bestandteile oder Ersetzungen durch technische Äquivalente sind, soweit sie im Rahmen des beanspruchten Schutzbegehrens bleiben, jederzeit möglich.

## Patentansprüche

1. Näherungsschalter oder -sensor, welcher nach einem induktiven oder kapazitiven Wirkprinzip arbeitet und einen LC-Schwingkreis und einen wirkverbundenden Verstärker beinhaltet, und bei welchem die Annäherung eines geeigneten beeinflussenden Elements oder Gegenstandes wenigstens einen Schwingungsparameter verändert, wobei der Schaltzustand des Verstärkers verändert wird wenn der Gegenstand einen bestimmten Abstand zum Schwingkreis unterschreitet, wobei die frei oder fremderregte Schwingung mit Erreichen des Schaltpunktes jedoch nicht, oder zumindest nicht sofort, abreisst, **dadurch gekennzeichnet dass** er ebenfalls Anzeigemittel (5) beinhaltet, welche in der Lage sind das Vorhandensein einer Beeinflussung des Schwingkreises (2) zu signalisieren, bevor der Schaltpunkt oder -wert des Verstärkes (3) erreicht wird.

2. Näherungsschalter gemäss Anspruch 1, **dadurch gekennzeichnet dass** die Anzeigemittel (5) auch dann noch aktiv sind, d. h. das Vorhandensein einer Beeinflussung des Schwingkreises (2) signalisieren, wenn der Schaltpunkt erreicht und überschritten ist.

3. Näherungsschalter gemäss einem der Ansprüche 1 und 2, **dadurch gekennzeichnet dass** die Anzeigemittel (5) so eingestellt sind, dass sie aktiv sind wenn die Intensität der Beeinflussung des Schwingkreises (2) innerhalb wenigstens eines Fühlungsbereichs (B) liegt, welcher den Intensitätwert (Is) der dem Schaltpunkt entspricht umgibt und beinhaltet.

4. Näherungsschalter gemäss einem der Ansprüche 1 und 2, **dadurch gekennzeichnet dass** die Anzeigemittel (5) aktiv sind solange sich die Intensität der Beeinflussung des Schwingkreises (2) überhalb eines ersten niedrigeren unteren Schwellenwertes (Iu) und unterhalb eines zweiten höheren oberen Schwellenwertes (Io) befindet, wobei diese Schwellenwerte den Intensitätswert (Is) der dem Schaltpunkt entspricht beidseitig umgeben.

5. Näherungsschalter gemäss Anspruch 4, **dadurch gekennzeichnet dass** der untere bzw. obere Schwellenwert (Iu, Io) ungefähr 5 % bis 20 %, vorzugsweise ungefähr 10 %, unter bzw. über dem Intensitätswert (Is) der dem Schaltpunkt entspricht, liegen.

6. Näherungsschalter gemäss einem der Ansprüche 3 bis 5, **dadurch gekennzeichnet dass** die Anzeigemittel (5), wenn sie aktiv sind, verschiedene Signale abgeben, je nachdem die Intensität der Beeinflussung des Schwingkreises (2) den Intensitätswert (Is), der dem Schaltpunkt entspricht, überschreitet hat oder nicht.

7. Näherungsschalter gemäss einem der Ansprüche 3 bis 6, **dadurch gekennzeichnet dass** der zur Bewertung der Beeinflussung des Schwingkreises (2) herangezogene Parameter aus der Gruppe ausgewählt ist, welche die Amplitude, die Phase und die Frequenz beinhaltet, und dass das von den Anzeigemitteln (5) abgegebene Signal eine Signal beliebiger Form ist, z.B. ein Rechtecksignal, welches den Zustand oder die Lage der momentanen Intensität der Beeinflussung des Schwingkreises (2) gegenüber dem Fühlungsbereich (B) und/oder den Schwellenwerten (Iu, Io) statisch, dynamisch, zeitlich verzögert oder mittels Einwirkung einer anderen Funktion angibt.

8. Näherungsschalter gemäss einem der Ansprüche 3 bis 7, **dadurch gekennzeichnet dass** der Fühlungsbereich (B) oder die Schwellenwerte einstellbar sind und dass die Anzeigemittel (5) einen Schaltverstärker (6) beinhalten oder dass diesen Anzeigemitteln (5) ein Schaltverstärker (6) wirkverbunden nachgeschaltet ist.

9. Anwendungsverfahren eines Näherungsschalters oder -sensors gemäss einem der Anspruch 1 bis 8, **dadurch gekennzeichnet dass** es hauptsächlich folgende Schritte aufweist:
- Montage des den Schalter oder Sensor (1) beinhaltenden Gehäuses (7) am Verwendungsort;
- Durchführung eines Kalibrierungs- bzw. Einstellungsvorganges des Schalters oder Sensors (1), nämlich des Schwingkreises (2) und der Anzeigemittel(5), und der gegebenenfalls jeweils wirkverbundenen Elektronik (3, 6), in Anwesenheit der anwendungsüblichen Arbeitsumgebung jedoch in Abwesenheit des im Arbeitsgang zu erfassenden, beeinflussenden Elements oder Gegenstandes (4), mindestens durch Entfernung aus dem Erfassungsbereich (E) des Schalters oder Sensors (1);
- Verwendung des eingestellten Schalters oder Sensors (1) als Näherungsschalter oder Anwesenheitsschalter, nach Beendigung des vorher gebenden Schritten.

10. Anwendungsverfahren nach Anspruch 9, **dadurch gekennzeichnet dass** der Kalibrierungs- bzw. Einstellungsvorgang wiederholt wird, zum Beispiel nach jeder Änderung der Arbeitsumgebung des Schalters oder Sensors (1), während das beeinflussende Element (4) weit ausserhalb des Erfassungsbereichs (E) liegt.
